# EUROPEAN PATENT APPLICATION

(11) **EP 4 770 383 A1**
(43) Date of publication of application: **01.07.2026**
(21) Application number: 25227177.0
(22) Date of filing: 24.12.2025
(51) Int. Cl.: H10K 59/131, H10K 71/00

(54) **DISPLAY PANEL**

(30) Priority: 30.12.2024 KR 20240200151
(71) Applicant: LG Display Co., Ltd., Seoul, 07336 (KR)
(72) Inventor: KIM, Won Doo, 10845 Paju-si (KR); KIM, Ju Hyuk, 10845 Paju-si (KR); KIM, Yong Hyeon, 10845 Paju-si (KR); SONG, Min Gyu, 10845 Paju-si (KR)
(74) Representative: Ambroz, Simon

(57) **Abstract**

A display panel according to an example of the present disclosure includes a first data line including a first multiple-wire part and a first single-wire part provided alternately in a first direction, and a second data line including a second multiple-wire part and a second single-wire part provided alternately in the first direction, the first multiple-wire part and the second single-wire part are provided in a second direction intersecting the first direction, and the first single-wire part and the second multiple-wire part are provided in the second direction.

## Description

### CROSS-REFERENCE TO RELATED APPLICATION

This application claims priority to and the benefit of Korean Patent Application No. 10-2024-0200151, filed DEC, 30, 2024.

### BACKGROUND

### Field

The present disclosure relates to a display panel, and specifically, to a display panel capable of preventing short-circuiting and improving an aperture ratio.

### Discussion of Related Art

With the advent of full-fledged information age, the field of display devices that visually represent electrical information signals is developing rapidly.

Representative examples of display devices may include liquid crystal display devices (LCD), organic light-emitting display devices (OLED), and quantum dot display devices.

In general, the display device includes a display panel, and a gate driving circuit and a source driving circuit that are electrically connected to the display panel and output gate signals and data signals, respectively.

The display panel may have a display area including a plurality of pixels and a non-display area where the gate driving circuit and the source driving circuit are provided around the display area. Here, in the display area, a plurality of pixels each including a light-emitting part and a circuit part are provided, and configurations such as various transistors, light-emitting elements, data lines, gate lines, driving voltage lines, reference voltage lines, and common voltage lines may be formed.

In this case, the display panel may have a problem in that short-circuiting occurs between adjacent data lines or overlapping data lines.

Further, the display panel has a problem in that the aperture ratio of the light-emitting part is reduced due to the configurations provided in the circuit part of each of the plurality of pixels.

### SUMMARY

A display panel according to an example of the present disclosure is intended to prevent short-circuiting between data lines provided adjacent to each other in a planar manner and data lines overlapping each other in a cross-sectional manner.

Further, the display panel according to the example of the present disclosure is intended to improve an aperture ratio of a light-emitting part by minimizing a repair area of a circuit part.

Objectives according to examples of the present disclosure are not limited to the above-described objectives, and other objectives that are not described herein will be apparently understood by those skilled in the art from the following description.

A display panel according to an example of the present disclosure includes a first data line including a first multiple-wire part and a first single-wire part provided alternately in a first direction, and a second data line including a second multiple-wire part and a second single-wire part provided alternately in the first direction, in which the first multiple-wire part and the second single-wire part are provided between the plurality of sub-pixels in a second direction intersecting the first direction , and the first single-wire part and the second multiple-wire part are provided between the plurality of sub-pixels in the second direction.

The display panel according to the example of the present disclosure can have an effect of minimizing short-circuiting between data lines provided adjacent to each other in a planar manner.

The display panel according to the example of the present disclosure can have an effect of maintaining luminance of sub-pixels uniformly and preventing short-circuiting between data lines provided adjacent to each other.

The display panel according to the example of the present disclosure can have an effect capable of improving the aperture ratio of the display panel.

The effects of the present disclosure are not limited to the effects mentioned above, and other effects not mentioned can be clearly understood by those skilled in the art to which the technical idea of the present disclosure pertains from the following description.

### BRIEF DESCRIPTION OF THE DRAWINGS

The above and other objects, features, and advantages of the present disclosure will become more apparent to those of ordinary skill in the art by describing exemplary examples thereof in detail with reference to the attached drawings, in which:
FIG. 1 is a plan view of a display panel according to an example of the present disclosure.
FIG. 2 is a circuit diagram of a sub-pixel circuit according to the example.
FIG. 3 is a plan view of the display area of the display panel according to the example of the present disclosure.
FIG. 4 is a circuit schematic diagram of FIG. 3.
FIG. 5 is a plan view illustrating data lines according to a first example.
FIG. 6 is an enlarged plan view of D1 and D2 areas in FIG. 5.
FIG. 7 is cross-sectional views taken along lines II-II' and III-III' in FIG. 5.
FIG. 8 is a plan view illustrating data lines according to a second example.
FIG. 9 is cross-sectional views taken along lines IV-IV' and V-V' in FIG. 8.
FIG. 10 is a plan view illustrating arrangement of semiconductor patterns according to the example.
FIG. 11 is a cross-sectional view taken along line VI-VI' in FIG. 10.
FIG. 12 is a schematic plan view illustrating an arrangement structure of an anode electrode and a light-shielding pattern according to the example of the present disclosure.
FIG. 13 is an enlarged plan view of an area A in FIG. 3 according to the example.
FIG. 14 is an enlarged plan view of an area C in FIG. 13.
FIGS. 15A to 15G are process views with respect to a cross-sectional view of FIG. 14 taken along line I-I'.
FIG. 16 is a plan view of a mask illustrated in FIG. 15B.

### DETAILED DESCRIPTION OF EXEMPLARY EXAMPLES

Advantages and features of the present disclosure and methods of achieving them will become apparent with reference to the following examples, which are described in detail, in conjunction with the accompanying drawings. However, the present disclosure is not limited to the examples to be described below and may be implemented in various different forms, the examples are only provided to completely disclose the present disclosure and completely convey the scope of the present disclosure to those skilled in the art.

The shapes, sizes, dimensions (e.g., length, width, height, thickness, radius, diameter, area, etc.), ratios, angles, number of elements, and the like illustrated in the accompanying drawings for describing the examples of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

The same reference number indicates the same components throughout the specification. Further, in describing the present disclosure, when it is determined that a detailed description of related known technology may unnecessarily obscure the gist of the present disclosure, the detailed description thereof will be omitted. When "providing," "including," "having," "consisting of," and the like mentioned in the present disclosure are used, other parts may be added unless 'only' is used. A case in which a component is expressed in a singular form may include a plural form unless explicitly stated otherwise.

In a description of a positional relationship, when the positional relationship of two parts such as "on," "at an upper portion," "at a lower portion," "next to," "adjacent to," or the like is described, one or more other parts may be located between two components unless "immediately", "directly," "close to" is used.

a description of a temporal relationship, when the temporal relationship is described as "after," "following," "and then," "before," or the like, non-consecutive cases may also be included unless "immediately" or "directly" is used.

Although first, second, and the like are used to describe various components, these components are not limited by these terms. These terms are only used to distinguish one component from another component.

The terms, such as first, second, A, B, (a), and (b) may be used to describe components of the present disclosure. These terms are only for the purpose of distinguishing one component from another component, and the nature, sequence, order, or the like of the corresponding components is not limited by these terms.

When a component is described as being "connected," "coupled," "linked," or "attached" to another component, it should be understood that the component may be directly connected, coupled, linked, or attached to the other component, but another component may be interposed between the components which may be indirectly connected, coupled, linked, or attached to each other unless explicitly stated otherwise.

When a component or layer is described as "in contact with" or "overlap" another component or layer, it should be understood that the component or layer may be in direct contact with or directly overlap another component or layer, but another component may be interposed between the components which may be in direct contact with or directly overlap each other unless explicitly stated otherwise.

To further elaborate, as used herein, the term "connected" is intended to have the broadest possible meaning. Specifically, the phrase "A is connected to B" encompasses both a direct connection-where no intervening components or elements are present- and an indirect connection, where one or more intermediate components or elements exist between A and B. In other words, "A is connected to B" includes both direct physical or electrical coupling and indirect coupling through one or more intervening components. Unless explicitly stated otherwise, these terms do not require direct physical or electrical contact. The term "coupled" and "in contact" should be interpreted in the same manner.

"At least one" should be understood as including a combination of one or more of the related components. For example, the term "at least one of first, second, and third components" includes not only the first, second, or third component, but also all combinations of two or more of the first, second, and third components.

The terms "a first direction," "a second direction," "a third direction," "an X-axis direction," "a Y-axis direction," and "a Z-axis direction" should not be understood as only a geometric relationship where a relationships therebetween are perpendicular to each other, but mean that a configuration of the present disclosure has a broader directionality within a range which may functionally acts.

Features of various examples of the present disclosure may be partially or entirely combined with each other, and technically, various linkages and operations are possible, and the examples may be implemented independently of each other or together in a related relationship. The scale of components shown in the drawings is not limited to the scale depicted in the drawings, as it differs from the actual scale for the sake of clarity.

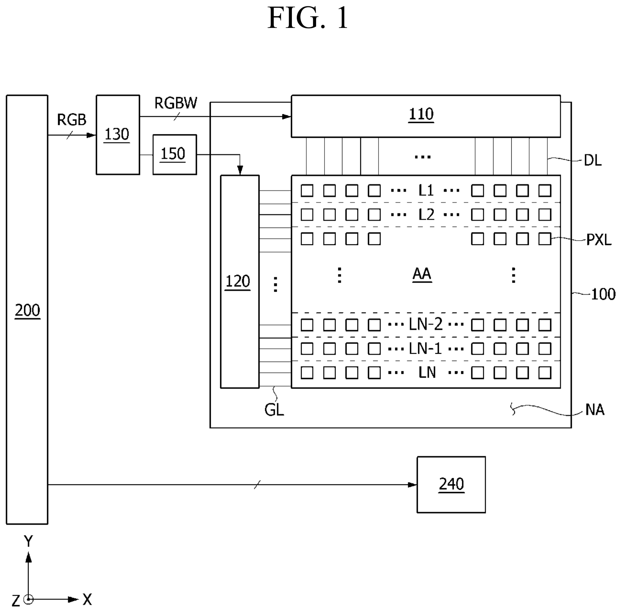

FIG. 1 is a plan view of a display panel according to an example of the present disclosure.

Referring to FIG. 1, a horizontal direction X and a vertical direction Y of a display panel 100 may be a lengthwise direction and a widthwise direction of the display panel 100, respectively. Further, the horizontal direction X and the vertical direction Y of the display panel 100 may also be expressed as a row direction and a column direction, respectively. A thickness direction Z may mean a direction perpendicular to a plane having the horizontal direction X and the vertical direction Y of the display panel 100. The display panel 100 may have a cross section in the thickness direction Z.

Referring to FIG. 1, the display panel 100 according to the example of the present disclosure may include a display panel driving circuit that writes pixel data to pixels, and a power supply 240 that generates electric power necessary for driving the pixels and the display panel driving circuit.

A display area AA of the display panel 100 may include a pixel array that displays an input image. The pixel array may include a plurality of data lines DL, a plurality of gate lines GL intersecting the data lines DL, and pixels PXL provided in a matrix. The display panel 100 may include power lines connected in common to the pixels. The power lines may be connected to constant voltage nodes of pixel circuits and may supply constant voltages necessary for driving the pixels PXL to the pixels PXL. The power lines may be implemented by stripe or mesh wires and may be connected in common to the pixels PXL of the display panel 100.

To implement a color, each of the pixels PXL may include a first sub-pixel, a second sub-pixel, a third sub-pixel, and a fourth sub-pixel having different colors. The color arrangement of the sub-pixels may be changed. The first sub-pixel may be a blue (B) sub-pixel, the second sub-pixel may be a green (G) sub-pixel, the third sub-pixel may be a red (R) sub-pixel, and the fourth sub-pixel may be a white (W) sub-pixel, but the examples of the present disclosure are not limited thereto.

Each of the sub-pixels may include a pixel circuit that drives a light-emitting element. The pixel circuit may be connected to the data line, the gate lines, and the power lines. Each sub-pixel may be divided into a circuit area and a light emission area. The pixel circuit may be provided in the circuit area. The light emission area is an area where light of the light-emitting element electrically connected to the pixel circuit is emitted.

The pixel array may include a plurality of pixel lines L1 to LN. Each of the pixel lines L1 to LN may include one line of pixels provided along the X-axis direction X in the pixel array of the display panel 100. The pixels provided in one pixel line may share the gate lines GL. The sub-pixels provided in a column direction along a data line direction may share the same data line DL. One horizontal period is a time obtained by dividing one frame period by the total number of pixel lines L1 to LN.

The power supply 240 outputs voltages necessary for driving the pixels and the display panel driving circuit of the display panel 100 using a DC-DC converter. The DC-DC converter may include a charge pump, a regulator, a buck converter, a boost converter, and the like.

The display panel driving circuit writes pixel data of an input image to the pixels of the display panel 100 under the control of a timing controller 130. The display panel driving circuit may include a data driver 110 and a gate driver 120.

The display panel driving circuit may drive the pixels by double rate driving (DRD). In the display panel that is driven by the DRD, since the data lines DL are connected to neighboring sub-pixels on right and left sides, the number of channels of the data driver 110 and the number of data lines DL are reduced, and it is advantageous in securing the aperture ratio of the pixels.

The display panel driving circuit may further include a touch sensor driver that drives touch sensors. The touch sensor driver is not shown in FIG. 1. The data driver 110 and the touch sensor driver may be integrated into one source drive integrated circuit (IC).

The data driver 110 may receive the pixel data of the input image received as a digital signal from the timing controller 130 and output a data voltage. The data driver 110 may convert the pixel data of the input image into a gamma compensation voltage for each frame period using a digital-to-analog converter (DAC) and output the data voltage. The data voltage may be output via an output buffer in each of the channels of the data driver 110.

The gate driver 120 may be formed in the display panel 100 along with a TFT array and the wires of the pixel array. The gate driver 120 may be provided in the non-display area NA of the display panel 100 or at least a part of the gate driver 120 may be provided in the display area AA where the input image is reproduced.

The gate driver 120 may be provided in the non-display area NA on both sides of the display panel 100 with the display area AA of the display panel 100 interposed therebetween and may supply gate pulses on both sides of the gate lines GL by a double feeding method. In another example, the gate driver 120 may be provided on one side of the right and left sides of the non-display area NA of the display panel 100 and may supply gate signals to the gate lines GL by a single feeding method. The gate driver 120 sequentially outputs pulses (hereinafter, referred to as gate pulses) of the gate signals to the gate lines GL under the control of the timing controller 130. The gate driver 120 may sequentially supply the gate signals to the gate lines GL by shifting the gate pulses using a shift register. The gate driver 120 may include one or more shift registers that output the pulses of the gate signals.

The timing controller 130 receives digital video data of the input image and timing signals synchronized with the data from a host system 200. The timing signals may include a vertical synchronization signal, a horizontal synchronization signal, a clock, a data enable signal, and the like. Since a vertical period and a horizontal period are known by a method for counting the data enable signals, the vertical synchronization signal and the horizontal synchronization signal may be omitted. The data enable signal has a cycle of one horizontal period (1 H). The timing controller 130 generates a data timing control signal for controlling an operation timing of the data driver 110 and a gate timing control signal for controlling an operation timing of the gate driver 120 on the basis of the timing signals received from the host system 200.

The timing controller 130 may convert three-primary color pixel data RGB of three primary colors input from the host system 200 into four-subcolor data RGBW by adding white data to the three-primary color pixel data RGB and transfer the four-subcolor data RGBW to the data driver 110. As a method for converting the pixel data RGB of the three primary colors into the four-subcolor data RGBW, a known color conversion algorithm may be used.

For example, the timing controller 130 may convert first pixel data into four-subcolor data RGBW by generating W data of the first pixel data on the basis of a minimum grayscale value among R data, G data, and B data of the first pixel data received from data of an input image. Further, the timing controller 130 may convert second pixel data into four-subcolor data RGBW by generating W data of the second pixel data on the basis of a minimum grayscale value among R data, G data, and B data of the second pixel data received from data of an input image.

In each of the first and second pixel data, the grayscale values of the R, G, and B data may be lowered by the W data. Here, the R data is data to be written to the red sub-pixel, and the G data is data to be written to the green sub-pixel. The B data is data to be written to the blue sub-pixel, and the W data is data to be written to the white sub-pixel.

The level shifter 150 may receive the gate timing control signal from the timing controller 130, generate a start pulse and a shift clock, and supply the start pulse and the shift clock to the gate driver 120. The start pulse and the shift clock output from the level shifter 150 swing between a gate high voltage and a gate low voltage.

The host system 200 may include a main board of one of a television (TV) system, a set-top box, a navigation system, a personal computer (PC), a system for a vehicle, a mobile terminal, and a wearable terminal. The host system 200 may scale an image signal from a video source in conformity with the resolution of the display panel 100 and transfer the image signal to the timing controller 130 along with the timing signals.

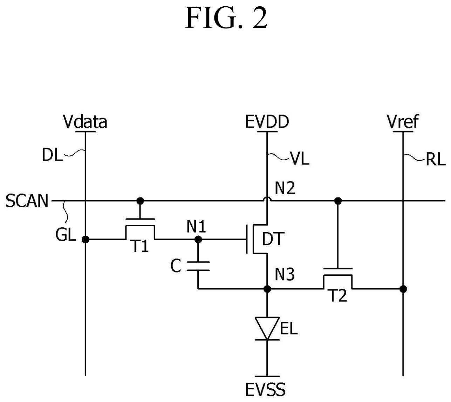

FIG. 2 is a circuit diagram of a sub-pixel circuit according to the example.

Referring to FIG. 2, a circuit (hereinafter, referred to as a sub-pixel circuit) for each sub-pixel PXL may be connected to the data line DL to which a data voltage Vdata of pixel data is applied, a gate line GL to which a gate pulse SCAN is applied, a driving voltage line VL to which the pixel driving voltage EVDD is applied, a low potential voltage line (or an electrode pattern) to which a low potential voltage EVSS is applied, and a reference voltage line RL to which a reference voltage Vref is applied.

Each sub-pixel circuit may include a light-emitting element EL, a plurality of transistors DT, T1, and T2, and a capacitor C. It should be noted that a sub-pixel circuit structure in the display panel of the present disclosure is not limited to the above-described structure.

The light-emitting element EL may be an organic light-emitting diode (OLED) or an inorganic light-emitting element such as a micro LED. The light-emitting element EL may include a red light-emitting element, a green light-emitting element, and a blue light-emitting element, but the examples of the present disclosure are not limited thereto. An anode electrode of the light-emitting element EL may be electrically connected to a driving element DT and may be provided in the corresponding light emission area in each pixel. The light-emitting element EL is driven to emit light when a current from the driving element DT is generated, and light is emitted outside the display panel via the light emission area.

The driving element DT may drive the light-emitting element EL by generating a current according to a gate-source voltage. The driving element DT includes a gate electrode connected to a first node N1, a first electrode connected to a second node N2, and a second electrode connected to a third node N3. The capacitor C is connected between the first node N1 and the third node N3. The second node N2 is connected to the driving voltage line VL. The third node N3 is connected to the anode electrode of the light-emitting element EL. A cathode electrode of the light-emitting element EL is connected to the low potential voltage line to which the low potential voltage EVSS is applied.

A first switch element T1 is connected between the data line DL and the first node N1. The first switch element T1 is turned on in response to the gate pulse SCAN. When the first switch element T1 is turned on, the data voltage Vdata of the pixel data is applied to the first node N1 and the pixel data is written to the sub-pixel. The first switch element T1 may include a gate electrode connected to the gate line GL, a first electrode connected to the data line DL, and a second electrode connected to the first node N1.

A second switch element T2 is connected between the third node N3 and the reference voltage line RL. The second switch element T2 is turned on in response to the gate pulse SCAN. When the second switch element T2 is turned on, the third node N3 is connected to the reference voltage line RL. The second switch element T2 includes a gate electrode connected to the gate line GL, a first electrode connected to the third node N3, and a second electrode connected to the reference voltage line RL.

While the driving elements DT should have uniform electrical characteristics in all sub-pixels, the electrical characteristics may be different between the sub-pixels due to process deviation and element characteristic deviation, and the difference may be increased with lapse of a driving time of each sub-pixel. To compensate for deviation in electrical characteristics of the driving elements DT, an external compensation circuit may be applied to the display panel driving circuit.

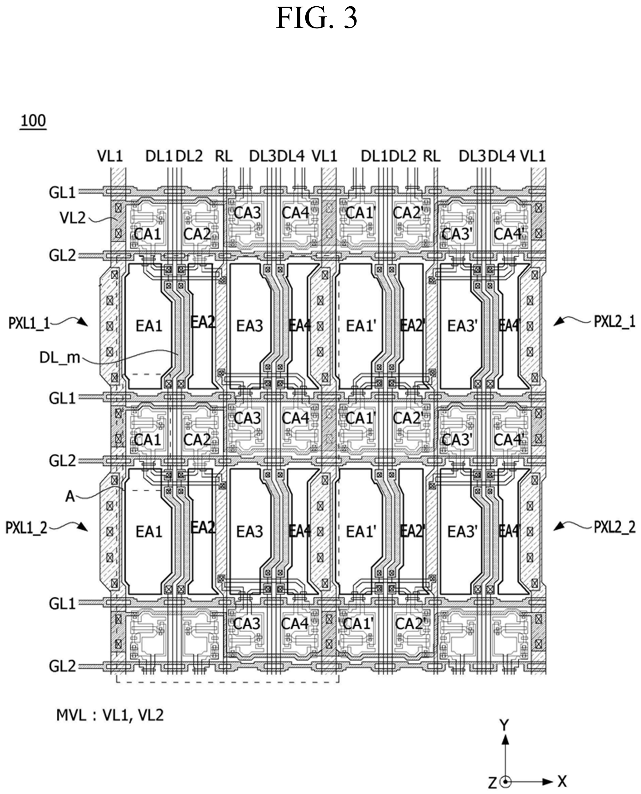

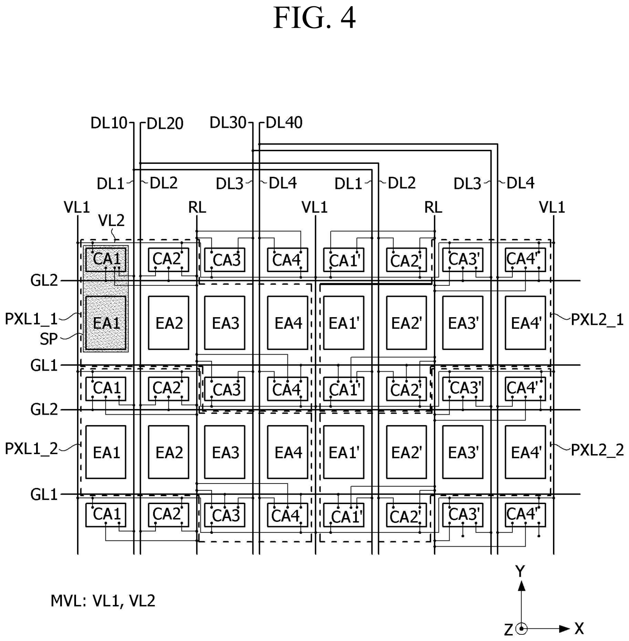

FIG. 3 is a plan view of the display area of the display panel according to the example of the present disclosure. FIG. 4 is a circuit schematic diagram of FIG. 3.

Referring to FIGS. 3 and 4, the display panel according to the example may include a plurality of pixels PXL1_1, PXL1_2, PXL2_1, and PXL2_2, and may include driving voltage lines MVL, reference voltage lines RL, data lines DL1, DL2, DL3, and DL4, and gate lines GL1 and GL2 that drive the plurality of pixels PXL1_1, PXL1_2, PXL2_1, and PXL2_2. The horizontal direction X of the display panel 100 may be in parallel with the gate lines GL1 and GL2, and the vertical direction Y may be in parallel with the driving voltage lines VL1, the reference voltage lines RL, and the data lines DL1, DL2, DL3, and DL4.

The plurality of pixels PXL1_1, PXL1_2, PXL2_1, and PXL2_2 may include a first_first pixel PXL1_1, a first_second pixel PXL1_2, a second_first pixel PXL2_1, and a second_second pixel PXL2_2.

The first_first pixel PXL1_1 and the first_second pixel PXL1_2 may have the same structure and may be provided repeatedly in the vertical direction Y. In this case, some circuit parts of the first_first and first_second pixels PXL1_1 and PXL1_2 may be provided in parallel in the horizontal direction X. For example, first and second circuit parts CA1 and CA2 of the first_first pixel PXL1_1 may be provided in parallel with third and fourth circuit parts CA3 and CA4 of the first_second pixel PXL1_2 in the horizontal direction X.

The second_first pixel PXL2_1 and the second_second pixel PXL2_2 may have the same structure and may be provided repeatedly in the vertical direction Y. In this case, some circuit parts of the second_first pixel PXL2_1 and the second_second pixel PXL2_2 may be provided in parallel in the horizontal direction X. For example, first prime and second prime circuit parts CA1' and CA2' of the second_first pixel PXL2_1 may be provided in parallel with third prime and fourth prime circuit parts CA3' and CA4' of the second_second pixel PXL2_2 in the horizontal direction X.

The first_first pixel PXL1_1 and the second_first pixel PXL2_1 may be provided repeatedly in the horizontal direction X. Further, the first_second pixel PXL1_2 and the second_second pixel PXL2_2 may be provided repeatedly in the horizontal direction X. Two pixels that are repeated in the horizontal direction X will be described with the first_first and second_first pixels PXL1_1 and PXL2_1 as an example.

In the first_first pixel PXL1_1 and the second_first pixel PXL2_1, first to fourth light-emitting parts EA (EA1, EA2, EA3, and EA4, and EA1', EA2', EA3', and EA4') are provided in order in the horizontal direction X. For example, with the driving voltage line VL1 between the first_first and second_first pixels PXL1_1 and PXL2_1 as a reference, the first to fourth light-emitting parts EA1, EA2, EA3, and EA4 are provided in order from the left on a left side, and the first to fourth light-emitting parts EA1', EA2', EA3', and EA4' of the second_first pixel PXL2_1 may be provided in order from the left on the right side.

Meanwhile, in the first_first pixel PXL1_1 and the second_first pixel PXL2_1, the first to fourth circuit parts CA (CA1, CA2, CA3, and CA4, and CA1', CA2', CA3', and CA4') may be provided horizontally symmetrically with the vertical direction Y as a reference. For example, with the driving voltage line VL1 between the first_first and second_first pixels PXL1_1 and PXL2_1 as a reference, the first to fourth circuit parts CA1, CA2, CA3, and CA4 provided on the left side may be symmetrical to the first to fourth circuit parts CA1', CA2', CA3', and CA4' of the second_first pixel PXL2_1 provided on the right side.

For example, the first and second circuit parts CA1 and CA2 of the first_first pixel PXL1_1 may be provided above the first and second light-emitting parts EA1 and EA2 corresponding to the first and second circuit parts CA1 and CA2. For example, the third and fourth circuit parts CA3 and CA4 of the first_first pixel PXL1_1 may be provided below the third and fourth light-emitting parts EA3 and EA4.

For example, the first prime and second prime circuit parts CA1' and CA2' of the second_first pixel PXL2_1 may be provided below the first prime and second prime light-emitting parts EA1' and EA2' corresponding to the first prime and second prime circuit parts CA1' and CA2'. For example, the third prime and fourth prime circuit parts CA3' and CA4' of the second_first pixel PXL2_1 may be provided above the third prime and fourth prime light-emitting parts EA3' and EA4' corresponding to the third prime and fourth prime circuit parts CA3' and CA4'. It should be noted that the arrangement structure of the plurality of pixels is for illustration, and the examples of the present disclosure are not limited thereto.

Each of a plurality of pixels PXL1_1 and PXL2_1 may include at least one sub-pixel (SP in FIG. 4). For example, the first_first pixel PXL1_1 may include a first sub-pixel including the first light-emitting part EA1 and the first circuit part CA1, a second sub-pixel including the second light-emitting part EA2 and the second circuit part CA2, a third sub-pixel including the third light-emitting part EA3 and the third circuit part CA3, and a fourth sub-pixel including the fourth light-emitting part EA4 and the fourth circuit part CA4.

For example, the second_first pixel PXL2_1 may include a first sub-pixel including the first prime light-emitting part EA1' and the first prime circuit part CA1', a second sub-pixel including the second prime light-emitting part EA2' and the second prime circuit part CA2', a third sub-pixel including the third prime light-emitting part EA3' and the third prime circuit part CA3', and a fourth sub-pixel including the fourth prime light-emitting part EA4' and the fourth prime circuit part CA4'.

Each of the plurality of pixels PXL1_1 and PXL2_1 may include sub-pixels that emit lights with different colors. For example, each of the plurality of pixels PXL1_1 and PXL2_1 may include a red sub-pixel, a green sub-pixel, a blue sub-pixel, and a white sub-pixel.

Referring to FIGS. 3 and 4, the first and first prime light-emitting parts EA1 and EA1' may emit red light as the first sub-pixel, the second and second prime light-emitting parts EA2 and EA2' may emit green light as the second sub-pixel, the third and third prime light-emitting parts EA3 and EA3' may emit white light as the third sub-pixel, and the fourth and fourth prime light-emitting parts EA4 and EA4' may emit blue light as the fourth sub-pixel. It should be noted that the types of the plurality of sub-pixels are for illustration, and the examples of the present disclosure are not limited thereto.

Each sub-pixel may be connected to the data line DL (DL1, DL2, DL3, or DL4), the gate line GL, the driving voltage line MVL, and the reference voltage line RL.

The data lines DL1 and DL2 or DL3 and DL4 may be provided between two sub-pixels between the driving voltage line VL1 and the reference voltage line RL. For example, the first and second data lines DL1 and DL2 may be provided between the sub-pixels SP that include the first and second light-emitting parts EA1 and EA2, respectively. For example, the third and fourth data lines DL3 and DL4 may be provided between the sub-pixels SP that include the third and fourth light-emitting parts EA3 and EA4.

The data lines DL1, DL2, DL3, and DL4 branch from corresponding main data lines DL10, DL20, DL30, and DL40 to two neighboring pixels PXL1_1 and PXL2_1, and may be driven by the DRD method.

For example, a first main data line DL10 may branch into two first data lines DL1 and may be connected to the first sub-pixels of the first_first pixel PXL1_1 and the second first_pixel PXL2_1. For example, a second main data line DL20 may branch into two second data lines DL2 and may be connected to the second sub-pixels of the first_first pixel PXL1_1 and the second_first pixel PXL2_1.

For example, a third main data line DL30 may branch into two third data lines DL3 and may be connected to the third sub-pixels of the first_first pixel PXL1_1 and the second first_pixel PXL2_1. For example, a fourth main data line DL40 may branch into two fourth data lines DL4 and may be connected to the fourth sub-pixels of the first_first pixel PXL1_1 and the second_first pixel PXL2_1.

Here, the first to fourth data lines DL1, DL2, DL3, and DL4 may form branch wires extending from the data lines DL1, DL2, DL3, and DL4 to the corresponding sub-pixels. Accordingly, the first to fourth data lines DL1, DL2, DL3, and DL4 may supply the data signal to the corresponding sub-pixels via the branch wires.

The two data lines branching from the main data line may have branch wires provided in different directions with respect to two different circuit parts provided in the same column. For example, out of two data lines branching from one main data line, one data line may have a branch wire provided above one circuit part, and the other data line may have a branch wire provided below the other circuit part.

Each of the data lines DL1, DL2, DL3, and DL4 may include a multiple-wire part DL_m. The multiple-wire part DL_m may be provided between two light-emitting parts (for example, EA1 and EA2). The multiple-wire part DL_m may be made in a shape in which two patterns overlap in the thickness direction Z.

As described above, since the data lines DL1, DL2, DL3, and DL4 that are driven by the DRD method are wires branching from the main data lines DL10, DL20, DL30, and DL40, line load may be increased. Here, the line load means that a signal is not transmitted at a normal speed due to load of a data transmission path or a path of an electrical signal.

For this reason, the display panel 100 according to the example of the present disclosure can reduce current resistance by forming the multiple-wire parts DL_m in the data lines DL1, DL2, DL3, and DL4. Accordingly, the display panel 100 according to the example of the present disclosure can reduce the line load of the data lines DL1, DL2, DL3, and DL4.

The gate lines GL (GL1 and GL2) may include a first gate line GL1 and a second gate line GL2. The first and second gate lines GL1 and GL2 may be provided repeatedly in the vertical direction Y. The first and second gate lines GL1 and GL2 adjacent to each other may be provided above and below of the circuit part CA with respect to the vertical direction Y.

For example, the first gate line GL1 may be provided above the circuit part CA with respect to the vertical direction Y, and the second gate line GL2 may be provided below the circuit part CA with respect to the vertical direction Y. The first and second gate lines GL1 and GL2 may correspond to two data lines branching from a main data line. Accordingly, even when the main data line supplies the same signal to the two data lines, the data lines may intersect the different first and second gate lines.

For example, the first gate line GL1 may supply a signal to the third circuit part CA3 and the fourth circuit part CA4 of the first_first pixel PXL1_1, and may supply a signal to the first circuit part CA1' and the second circuit part CA2' of the second_first pixel PXL2_1. For example, the second gate line GL2 may supply a signal to the first circuit part CA1 and the second circuit part CA2 of the first_first pixel PXL1_1, and may supply a signal to the third circuit part CA3' and the fourth circuit part CA4' of the second _first pixel PXL2_1.

In this case, for the first_first pixel PXL1_1, the first sub-pixel may be formed at an intersection point of the second gate line GL2 and the first data line DL1, the second sub-pixel may be formed at an intersection point of the second gate line GL2 and the second data line DL2, the third sub-pixel may be formed at an intersection point of the first gate line GL1 and the third data line DL3, and the fourth sub-pixel may be formed at an intersection point of the first gate line GL1 and the fourth data line DL4.

For the second_first pixel PXL2_1, the first sub-pixel may be formed at an intersection point of the first gate line GL1 and the first data line DL1, the second sub-pixel may be formed at an intersection point of the first gate line GL1 and the second data line DL2, the third sub-pixel may be formed at an intersection point of the second gate line GL2 and the third data line DL3, and the fourth sub-pixel may be formed at an intersection point of the second gate line GL2 and the fourth data line DL4.

In other words, in the DRD method, the first_first and second_first pixels PXL1_1 and PXL2_1 may receive signals from the same main data line DL10, DL20, DL30, or DL40, but may be driven individually by different gate signals GL1 and GL2.

For example, the first sub-pixel of the first_first pixel PXL1_1 may be driven by the first data line DL1 branching left from the first main data line DL10 and the second gate line GL2, and the first sub-pixel of the second_first pixel PXL2_1 may be driven by the first data line DL1 branching right from the first main data line DL10 and the first gate line GL1.

For example, the second sub-pixel of the first_first pixel PXL1_1 may be driven by the second data line DL2 branching left from the second main data line DL20 and the second gate line GL2, and the second sub-pixel of the second_first pixel PXL2_1 may be driven by the second data line DL2 branching right from the second main data line DL20 and the first gate line GL1.

For example, the third sub-pixel of the first_first pixel PXL1_1 may be driven by the third data line DL3 branching left from the third main data line DL30 and the first gate line GL1, and the third sub-pixel of the second first_pixel PXL2_1 may be driven by the third data line DL3 branching right from the third main data line DL30 and the second gate line GL2.

For example, the fourth sub-pixel of the first_first pixel PXL1_1 may be driven by the fourth data line DL4 branching left from the fourth main data line DL40 and the first gate line GL1, and the fourth sub-pixel of the second_first pixel PXL2_1 may be driven by the fourth data line DL4 branching right from the fourth main data line DL40 and the second gate line GL2.

The driving voltage line MVL according to the example of the present disclosure may include the driving voltage lines VL1 provided in the vertical direction Y, and driving voltage connection patterns VL2 that connect the driving voltage lines VL1. The driving voltage lines VL1 and the driving voltage connection patterns VL2 may be made to intersect each other in a mesh. It should be noted that the form of the driving voltage line MVL of the display panel of the present disclosure is not limited thereto.

Each of the driving voltage lines VL1 may be provided for each area between the first_first and second_first pixels PXL1_1 and PXL2_1. In other words, the driving voltage lines VL1 may be spaced apart from each other with the first_first pixel PXL1_1 or the second_first pixel PXL2_1 interposed therebetween.

The driving voltage connection patterns VL2 may connect the driving voltage lines VL1. The driving voltage connection patterns VL2 may be provided between the first and second gate lines GL1 and GL2 adjacent to each other. The driving voltage connection patterns VL2 may be horizontally symmetrical with respect to the driving voltage line VL1 provided between the first_first and second_first pixels PXL1_1 and PXL2_1.

Each of the driving voltage connection patterns VL2 may include overlap parts that overlap the driving voltage lines VL1, and connection lines between the overlap parts. Here, the driving voltage connection patterns VL2 may be in contact with the driving voltage lines VL1 in the overlap parts. The driving voltage connection patterns VL2 may be provided in a shape in which the overlap parts and the connection lines are repeated. In this case, the overlap parts and the connection lines of the driving voltage connection patterns VL2 may be made integrally.

The connection line of each of the driving voltage connection patterns VL2 may have an area overlapping the reference voltage line RL.

The reference voltage line RL may be provided between the driving voltage lines VL1. For example, the reference voltage line RL may be provided between the second and third data lines DL2 and DL3.

The reference voltage line RL may supply the reference voltage to each of the sub-pixels provided on both sides in the horizontal direction X. For example, the reference voltage line RL may be connected to the sub-pixels via branch wires extending from the reference voltage line RL to the circuit parts of the respective sub-pixels.

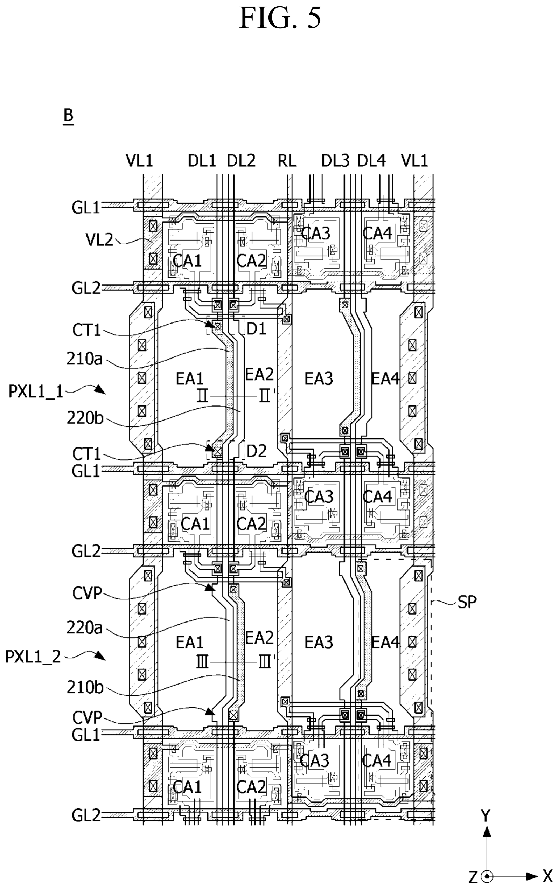

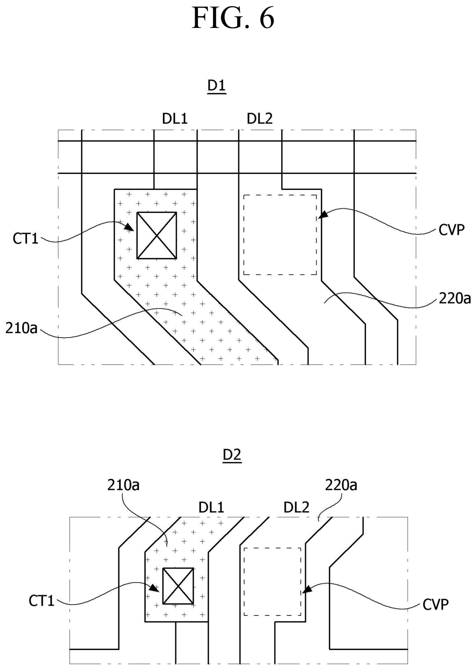

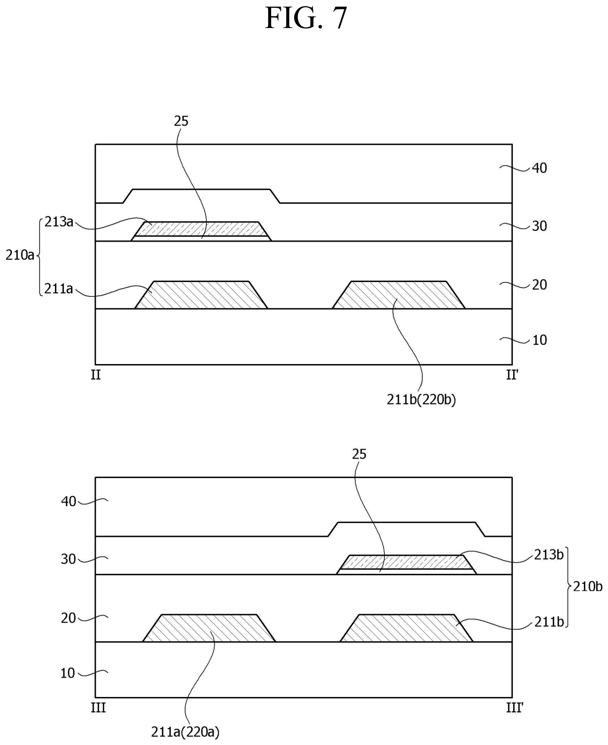

FIG. 5 is a plan view illustrating data lines according to a first example. FIG. 6 is an enlarged plan view of D1 and D2 areas in FIG. 5. FIG. 7 is cross-sectional views taken along lines II-II' and III-III' in FIG. 5. Hereafter, description of the same configurations as described above will not be repeated.

Referring to FIGS. 5 to 7, a display panel according to the first example of the present disclosure includes a first data line DL1 including a first multiple-wire part 210a ad a first single-wire part 220a provided alternately in a first direction Y, and a second data line DL2 including a second multiple-wire part 210b and a second single-wire part 220b provided alternately in the first direction Y, the first multiple-wire part 210a and the second single-wire part 220b are provided between the plurality of sub-pixels SP in a second direction X intersecting the first direction Y, and the first single-wire part 220a and the second multiple-wire part 220b are provided between the plurality of sub-pixels SP in the second direction Y.

Referring to FIGS. 5 to 7, the display panel according to the first example of the present disclosure may include data lines DL1, DL2, DL3, and DL4 including the first multiple-wire part 210a, the second multiple-wire part 210b, the first single-wire part 220a, and the second single-wire part 220b. Each of the multiple-wire parts 210a and 210b and the single-wire parts 220a and 220b according to the first example may be provided in units of sub-pixels.

Each of the multiple-wire parts 210a and 210b and each of the single-wire parts 220a and 220b may be provided between two light-emitting parts (for example, EA1 and EA2) provided repeatedly in the first direction Y. That is, each of the multiple-wire parts 210a and 210b and each of the single-wire parts 220a and 220b may be provided repeatedly in the first direction Y. Here, the first direction Y may be the vertical direction or the widthwise direction of the display panel.

For example, the first data line DL1 may include the first multiple-wire part 210a and the first single-wire part 220a. Here, the first multiple-wire part 210a and the first single-wire part 220a of the first data line DL1 may be provided alternately in the first direction Y.

For example, the second data line DL2 may include the second multiple-wire part 210b and the second single-wire part 220b. Here, the second multiple-wire part 210b and the second single-wire part 220b of the second data line DL2 may be provided alternately in the first direction Y.

In this case, the first multiple-wire part 210a of the first data line DL1 and the second single-wire part 220b of the second data line DL2 may be provided in parallel in the second direction X. The first single-wire part 220a of the first data line DL1 and the second multiple-wire part 210b of the second data line DL2 may be provided in parallel in the second direction X. Here, the second direction X is a direction intersecting the first direction Y, and may be the horizontal direction or the lengthwise direction of the display panel.

Referring to FIG. 7, the display panel according to the example of the present disclosure may include a substrate 10, a first data wire part 211a and a second data wire part 211b spaced apart from each other on the substrate 10, a buffer layer 20 provided on the first and second data wire parts 211a and 211b, a first overlap pattern 213a and a second overlap pattern 213b provided on the buffer layer 20, an interlayer insulating film 25 interposed between the buffer layer 20 and the first and second overlap patterns 213a and 213b, a passivation layer 30 provided on the first and second overlap patterns 213a and 213b, and an overcoat layer 40 provided on the passivation layer 30.

Here, the first multiple-wire part 210a of the first data line DL1 may include the first data wire part 211a and the first overlap pattern 213a. The first data wire part 211a and the first overlap pattern 213a may overlap each other. The first data wire part 211a and the first overlap pattern 213a may be in contact with each other via first contacts CT1 provided on both sides of the first overlap pattern 213a with respect to the first direction Y.

The first data wire part 211a may be the first data line DL1 provided in the first direction Y over the entire display area. The first overlap pattern 213a may be provided between the first and second light-emitting parts EA1 and EA2 in the first direction Y along the first data wire part 211a.

The first single-wire part 220a of the first data line DL1 may be a wire extending from the first data wire part 211a of the first multiple-wire part 210a.

The second multiple-wire part 210b of the second data line DL2 may include the second data wire part 211b and the second overlap pattern 213b. The second data wire part 211b and the second overlap pattern 213b may overlap each other. The second data wire part 211b and the second overlap pattern 213b may be in contact with each other via first contacts CT1 provided on both sides of the second overlap pattern 213b with respect to the first direction Y.

The second data wire part 211b may be the second data line DL2 provided in the first direction Y over the entire display area. The second overlap pattern 213b may be provided between the first and second light-emitting parts EA1 and EA2 in the first direction Y along the second data wire part 211b.

The second single-wire part 220b of the second data line DL2 may be a wire extending from the second data wire part 211b of the second multiple-wire part 210b.

Here, the first data wire part 211a and the second data wire part 211b may be provided in the same layer. The first overlap pattern 213a and the second overlap pattern 213b may be provided in the same layer.

In this case, the first multiple-wire part 210a of the first data line DL1 may be spaced apart from the second single-wire part 220b of the second data line DL2 in the second direction X, and the first single-wire part 220a of the first data line DL1 may be spaced apart from the second multiple-wire part 210b of the second data line DL2 in the second direction X.

Accordingly, the first and second overlap patterns 213a and 213b of the respective first and second data lines DL1 and DL2 are not provided adjacent to each other in the second direction X. Therefore, with the display panel according to the example of the present disclosure, it is possible to prevent short-circuiting between the first and second overlap patterns 213a and 213b provided in the same layer, and to prevent signal delay due to the line load of the data lines DL1, DL2, DL3, and DL4 branching from the main data lines (DL10, DL20, DL30, and DL40 in FIG. 4).

Referring to FIG. 6, the first and second single-wire parts 220a and 220b may include mask patterns CVP. The mask patterns CVP may have the same area as that of the first contacts CT1 provided in each of the first and second overlap patterns 213a and 213b. Here, the area may be formed on a plane having the first direction X and the second direction Y.

For example, a planar shape of each of the first and second single-wire parts 220a and 220b may be almost the same as that of each of the first and second overlap patterns 213a and 213b. For example, the number of mask patterns CVP provided in each of the first and second single-wire parts 220a and 220b may be the same as the number of first contacts CT1 provided in each of the first and second overlap patterns 213a and 213b.

Each of the first and second single-wire parts 220a and 220b includes the mask patterns CVP with the area corresponding to the area of the first contact CT1 in each of the first and second multiple-wire parts 220a and 220b, making it possible to adjust the areas of the first and second multiple-wire parts 220a and 220b and the first and second single-wire parts 220a and 220b at the same level. Therefore, the first and second multiple-wire parts 220a and 220b and the first and second single-wire parts 220a and 220b can block light emitted from the light-emitting parts EA1 and EA2 provided in parallel in the first direction Y uniformly.

Here, the light-emitting parts EA1, EA2, EA3, and EA4 that emit light of the same color may be provided in the first direction Y. Light emitted from the light-emitting parts EA1, EA2, EA3, and EA4 provided in the first direction Y may be not emitted to the outside and may be blocked by various signal wires (for example, VL1, VL2, GL1, GL2, RL, DL1, DL2, DL3, and DL4). In this case, the light-emitting parts of the same color provided in the first direction Y may have a luminance difference when the areas of the signal wires provided repeatedly in the respective light-emitting parts are different.

For this reason, with the display panel according to the example of the present disclosure, it is possible to prevent the occurrence of the luminance difference by forming the multiple-wire part (for example, the first multiple-wire part 210a) and the single-wire part (for example, the first single-wire part 220a) having the same area for the light-emitting parts EA1, EA2, EA3, and EA4 of the same color provided in the first direction Y.

On the other hand, the third and fourth data lines DL3 and DL4 may have a multiple-wire part and single-wire part of the same structure as those of the first and second data lines DL1 and DL2. Further, the data lines may have the same structure in other pixels (for example, PXL2_1).

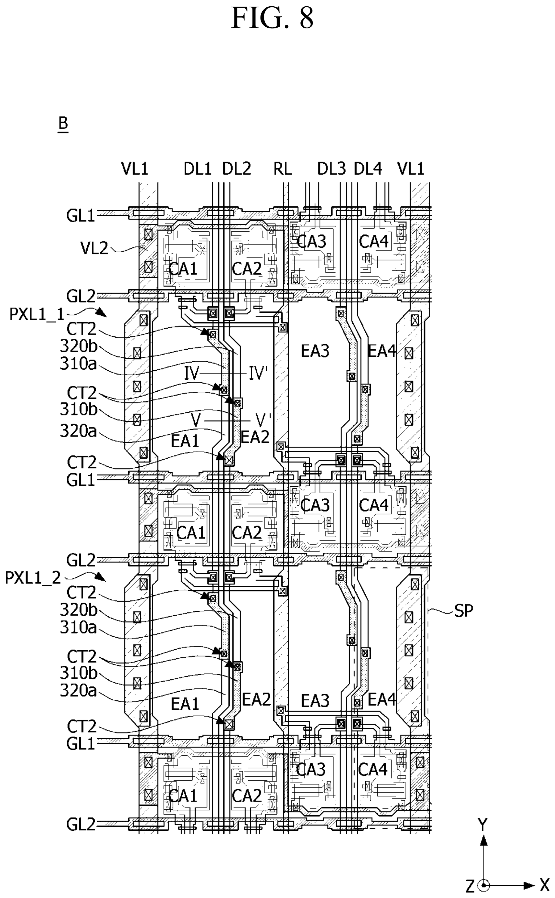

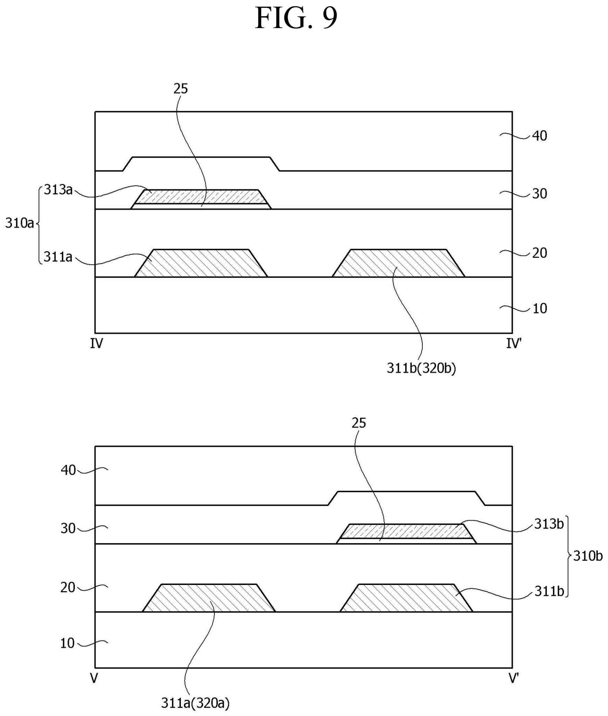

FIG. 8 is a plan view illustrating data lines according to a second example. FIG. 9 is cross-sectional views taken along lines IV-IV' and V-V' in FIG. 8.

Referring to FIGS. 8 and 9, a display panel according to a second example of the present disclosure may include data lines DL1, DL2, DL3, and DL4 each including a first multiple-wire part 310a or a second multiple-wire part 310b and a first single-wire part 320a or a second single-wire part 320b. In one data line (for example, DL1) according to the second example, one multiple-wire part (for example, 310a) and one single-wire part (for example, 320a) may be repeated in units of sub-pixels SP.

Each of the multiple-wire parts 310a and 310b and each of the single-wire parts 320a and 320b may be provided repeatedly in the first direction Y. That is, one multiple-wire part and one single-wire part in one data line may be provided between two light-emitting parts (for example, EA1 and EA2) provided repeatedly in the first direction Y.

For example, the first data line DL1 may include the first multiple-wire part 310a and the first single-wire part 320a. Here, the first data line DL1 may have one first multiple-wire part 310a and one first single-wire part 320a provided corresponding to one sub-pixel SP. Each first multiple-wire part 310a and each first single-wire part 320a may be provided alternately in the first direction Y.

For example, the second data line DL2 may include the second multiple-wire part 310b and the second single-wire part 320b. Here, the second data line DL2 may have one second multiple-wire part 310b and one second single-wire part 320b provided corresponding to one sub-pixel SP. Each second multiple-wire part 310b and each second single-wire part 320b may be provided alternately in the first direction Y.

That is, the first multiple-wire part 310a of the first data line DL1 and the second single-wire part 320b of the second data line DL2 may be provided between two sub-pixels SP in units of sub-pixels SP.

In this case, the first multiple-wire part 310a of the first data line DL1 and the second single-wire part 320b of the second data line DL2 may be provided in parallel in the second direction X. The first single-wire part 320a of the first data line DL1 and the second multiple-wire part 310b of the second data line DL2 may be provided in parallel in the second direction X.

Referring to FIG. 9, the display panel of according to the second example the present disclosure may include a first data wire part 311a and a second data wire part 311b spaced apart from each other on the substrate 10, and a first overlap pattern 313a and a second overlap pattern 313b provided on the buffer layer 20.

The first multiple-wire part 310a of the first data line DL1 may include the first data wire part 311a and the first overlap pattern 313a. The first data wire part 311a and the first overlap pattern 313a may overlap each other. The first data wire part 311a and the first overlap pattern 313a may be in contact with each other via second contacts CT2 provided on both sides of the first overlap pattern 313a with respect to the first direction Y.

The first data wire part 311a may be the first data line DL1 provided in the first direction Y over the entire display area. The first overlap pattern 313a may be provided between the first and second light-emitting parts EA1 and EA2 in the first direction Y along a part of the first data wire part 311a.

The first single-wire part 320a of the first data line DL1 may be a wire extending from the first data wire part 311a of the first multiple-wire part 310a.

The second multiple-wire part 310b of the second data line DL2 may include the second data wire part 311b and the second overlap pattern 313b. The second data wire part 311b and the second overlap pattern 313b may overlap each other. The second data wire part 311b and the second overlap pattern 313b may be in contact with each other via second contacts CT2 provided on both sides of the second overlap pattern 313b with respect to the first direction Y.

The second data wire part 311b may be the second data line DL2 provided in the first direction Y over the entire display area. The second overlap pattern 313b may be provided between the first and second light-emitting parts EA1 and EA2 in the first direction Y along a part of the second data wire part 311b.

The second single-wire part 320b of the second data line DL2 may be a wire extending from the second data wire part 311b of the second multiple-wire part 310b.

Here, the first data wire part 311a and the second data wire part 311b may be provided in the same layer. The first overlap pattern 313a and the second overlap pattern 313b may be provided in the same layer.

In this case, the first multiple-wire part 310a of the first data line DL1 may be spaced apart from the second single-wire part 320b of the second data line DL2 in the second direction X, and the first single-wire part 320a of the first data line DL1 may be spaced apart from the second multiple-wire part 310b of the second data line DL2 in the second direction X.

Accordingly, the first and second overlap patterns 313a and 313b of the respective first and second data lines DL1 and DL2 do not overlap each other in the second direction X. In other words, the first and second overlap patterns 313a and 313b are not provided adjacent to each other in the second direction X. Therefore, with the display panel according to the example of the present disclosure, it is possible to prevent short-circuiting between the first and second overlap patterns 313a and 313b provided in the same layer, and to prevent signal delay due to the line load of the data lines DL1, DL2, DL3, and DL4 branching from the main data lines (DL10, DL20, DL30, and DL40 in FIG. 4).

Further, since the multiple-wire part 310a or 310b and the single-wire part 320a or 320b are arranged in units of sub-pixels SP, the degree to which light emitted from the light-emitting parts EA1 and EA2 is blocked is uniform for each sub-pixel SP. Accordingly, with the single-wire parts 320a and 320b according to the second example, a separate pattern for making the luminance of the sub-pixels SP uniform may not be formed. It should be noted that, in the display panel according to the second example of the present disclosure, the shape of the single-wire parts 320a and 320b is not limited thereto.

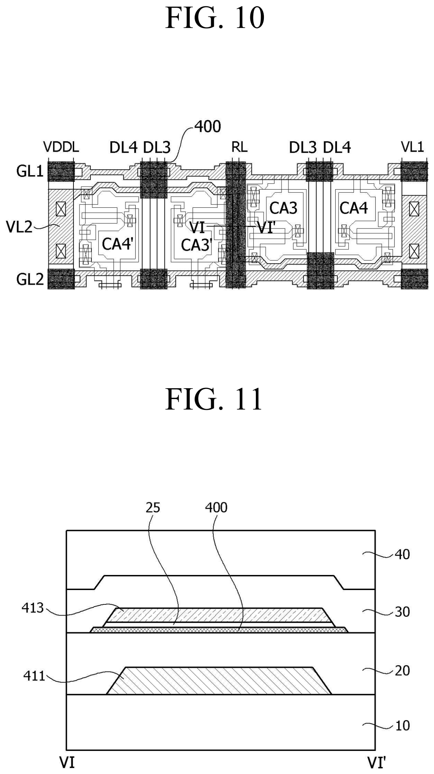

FIG. 10 is a plan view illustrating arrangement of semiconductor patterns according to the example. FIG. 11 is a cross-sectional view taken along line VI-VI' in FIG. 10.

Referring to FIG. 10, the display panel according to the example of the present disclosure may include semiconductor patterns 400.

The semiconductor patterns 400 may be provided between two wires that are provided in different layers and overlap each other. For example, the semiconductor patterns 400 may be provided between the driving voltage line VL1 and the first and second gate lines GL1 and GL2 overlapping each other, the first to fourth data lines DL1, DL2, DL3, and DL4 and the first and second gate lines GL1 and GL2 overlapping each other, between the reference voltage line RL and the first and second gate lines GL1 and GL2 overlapping each other, and the reference voltage line RL and the driving voltage connection pattern VL2.

It should be noted that, in the display panel according to the example of the present disclosure, the positions and structures of the semiconductor patterns 400 are not limited thereto. For example, the semiconductor patterns 400 are not limited to a DRD structure illustrated in the drawing, and may be applied to 1-gate-1-data (1G1D) or may be applied between all two wires provided in different layers.

Referring to FIG. 11, a first wire 411 may be provided on the substrate 10, the semiconductor pattern 400 may be provided on the buffer layer 20, and a second wire 413 may be provided on the semiconductor pattern 400 with a gate insulating film 25 interposed therebetween.

Here, the first wire 411 may be the reference voltage line RL, and the second wire 413 may be the driving voltage connection pattern VL2. In some cases, the first wire 411 may include the driving voltage line VL1 and the first to fourth data lines DL1, DL2, DL3, and DL4. In some cases, the second wire 413 may include the first and second gate lines GL1 and GL2.

The semiconductor patterns 400 are provided between two wires 411 and 413 provided in different layers, making it possible to reduce short-circuiting (vertical short-circuiting) in the vertical direction (thickness direction) Z due to foreign substances. Here, the driving voltage connection pattern VL2 may have a first section that overlaps the reference voltage line RL along the first direction Y.

For this reason, with the display panel according to the example of the present disclosure, it is possible to reduce vertical short-circuiting due to foreign substances by providing the semiconductor pattern 400 between the driving voltage connection pattern VL2 and the reference voltage line RL that overlap each other over an area of a comparatively long section, compared to other wires that overlap each other.

For example, the semiconductor patterns 400 may be made of a kind of nonconductor material or semiconductor material. For example, the semiconductor patterns 400 may contain one of silicon (Si), polysilicon (Poly-Si), indium gallium zinc oxide (IGZO), and gallium nitride (GaN).

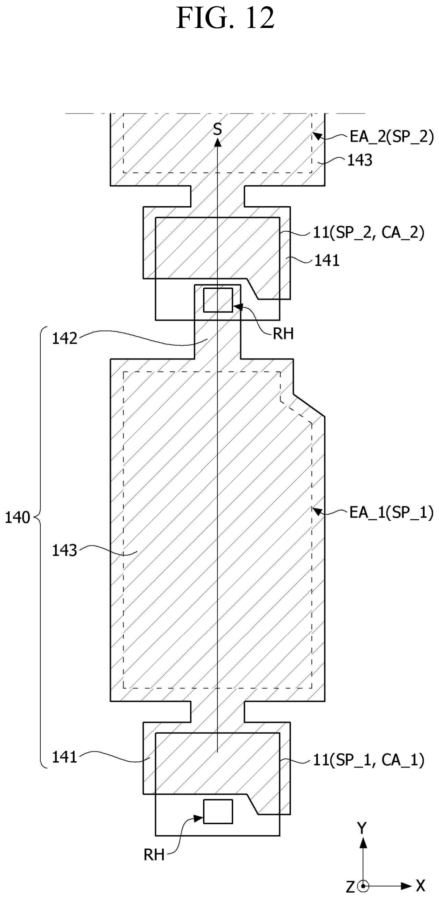

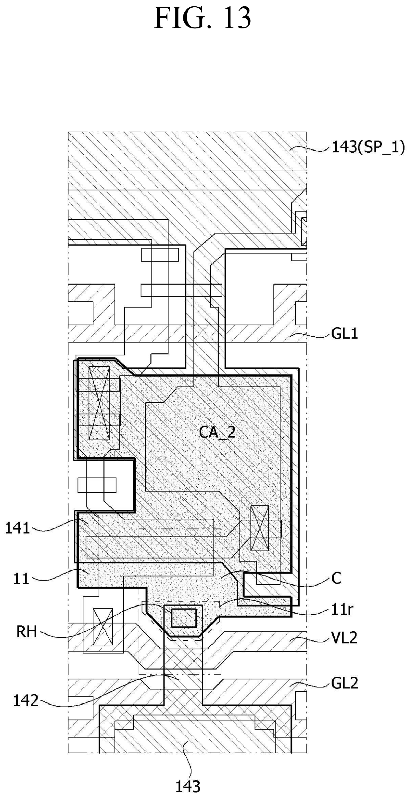

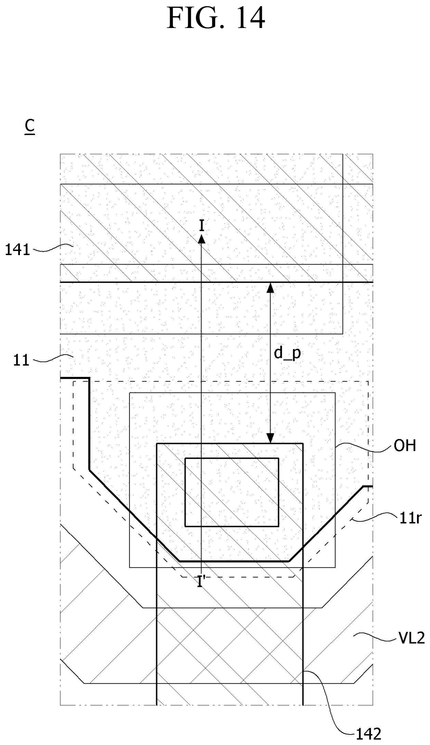

FIG. 12 is a schematic plan view illustrating an arrangement structure of an anode electrode and a light-shielding pattern according to the example of the present disclosure. FIG. 13 is an enlarged plan view of an area A in FIG. 3 according to the example. FIG. 14 is an enlarged plan view of an area C in FIG. 13.

Referring to FIGS. 12 to 14, the display panel according to the example may include an anode electrode 140, a light-shielding pattern 11 including a repair area 11r, a buffer layer 20 and a passivation layer 30 including a repair groove RH, and an overcoat layer 40 including a hole OH. The buffer layer 20 and a passivation layer 30 may be collectively referred to as an insulating layer.

Referring to FIGS. 12 to 14, the anode electrode 140 may include a first portion 141, a second portion 143, and a repair pattern 142. The anode electrode 140 may be provided in each of a plurality of sub-pixels SP_1 and SP_2. The anode electrode 140 may be provided in the light-emitting part EA_1 or EA_2 and the circuit part CA_1 or CA_2 of the sub-pixel SP_1 or SP_2, and a part thereof may extend from the light-emitting part EA_1 or EA_2 and may be provided in the other neighboring sub-pixel SP_1 or SP_2.

The first portion 141 of the anode electrode 140 may be provided in the circuit part CA_1 or CA_2. Here, the light-shielding pattern 11 may be provided entirely in the circuit part CA_1 or CA_2. In this case, the first portion 141 of the anode electrode 140 may overlap the circuit part CA_1 or CA_2 excluding the repair pattern 142 of the circuit part CA_1 or CA_2.

For example, a first portion 141 of an anode electrode 140 provided in a certain first sub-pixel SP_1 may be provided in a first circuit part CA_1. For example, a first portion 141 of an anode electrode 140 provided in a second sub-pixel SP_2 neighboring to the certain first sub-pixel SP_1 in the first direction Y may be provided in a second circuit part CA_2.

The second portion 143 of the anode electrode 140 may include the light-emitting part EA_1 or EA_2. The second portion 143 of the anode electrode 140 may be provided between the first portion 141 and the repair pattern 142.

For example, a second portion 143 of the anode electrode 140 provided in the certain first sub-pixel SP_1 may be provided in a first light-emitting part EA_1. For example, a second portion 143 of the anode electrode 140 provided in the second sub-pixel SP_2 neighboring to the certain first sub-pixel SP_1 in the first direction Y may be provided in a second light-emitting part EA_2.

The repair pattern 142 of the anode electrode 140 may extend from the second portion 143 and overlap the repair groove RH provided in the circuit part CA_1 or CA_2 of the other neighboring sub-pixel SP_1 or SP_2. Further, the repair pattern 142 of the anode electrode 140 may extend from the sub-pixel SP_1 or SP_2 and overlap the hole OH to the minimum in a remaining area excluding an area that passes through the hole OH of the overcoat layer 40, and an area that overlaps the repair groove RH.

For example, a repair pattern 142 of the anode electrode 140 provided in the certain first sub-pixel SP_1 may overlap a repair groove RH provided in the neighboring second sub-pixel SP_2.

The first portion 141 and the repair pattern 142 of the anode electrodes 140 of the neighboring sub-pixels SP_1 and SP_2 may have a first distance d_p. The first distance d_p may be a shortest distance at which the first portion 141 and the repair pattern 142 face each other.

The light-shielding pattern 11 may be provided in each of a plurality of circuit parts CA_1 and CA_2 of a plurality of sub-pixels SP_1 and SP_2. The light-shielding pattern 11 may overlap a plurality of transistors provided in each of the circuit parts CA_1 and CA_2.

The repair area 11r of the light-shielding pattern 11 may have a shape partially protruding from an area overlapping the plurality of transistors toward the neighboring sub-pixel SP_1 or SP_2. The repair area 11r of the light-shielding pattern 11 may not overlap the first portion 141 of the anode electrode 140 of the corresponding sub-pixel SP_1 or SP_2 and may overlap the repair pattern 142 of the anode electrode 140 of the neighboring sub-pixel SP_1 or SP_2. It should be understood that the repair area 11r is not limited to a specific region illustrated as including the repair groove RH and the hole OH, and may be modified in various forms or positions depending on design requirements.

For example, a repair area 11r of a light-shielding pattern 11 provided in a certain second sub-pixel SP_2 may not overlap a first portion 141 of an anode electrode 140 provided in the certain second sub-pixel SP_2 and may overlap a repair pattern 142 of an anode electrode 140 provided in a neighboring first sub-pixel SP_1.

The repair area 11r of the light-shielding pattern 11 can repair the corresponding sub-pixel SP_1 or SP_2 when the corresponding sub-pixel SP_1 or SP_2 operates abnormally. Here, the corresponding sub-pixel SP_1 or SP_2 may mean the sub-pixel SP_1 or SP_2 where the light-shielding pattern 11 is provided. The repair area 11r of the light-shielding pattern 11 can repair the corresponding sub-pixel SP_1 or SP_2 by coming into contact with the repair pattern 142 of the anode electrode 140 of the neighboring sub-pixel SP_1 or SP_2 through a laser process and copying data of the neighboring sub-pixel SP_1 or SP_2.

For example, when a certain second sub-pixel SP_2 operates abnormally, a repair region 11r of a light-shielding pattern 11 provided in the certain second sub-pixel SP_2 and a repair pattern 142 of an anode electrode 140 provided in a neighboring first sub-pixel SP_1 may be brought into contact with each other through the laser process. Then, data of the neighboring first sub-pixel SP_1 may be copied to the certain second sub-pixel SP_2 and the certain second sub-pixel SP_2 may be driven normally.

Here, through a signal path S of the coped data, when a driving signal is supplied from the first circuit part CA_1 of the first sub-pixel SP_1 to the anode electrode 140, the driving signal supplied to the first sub-pixel SP_1 may be supplied to the second circuit part CA_2 of the second sub-pixel SP_2.

The repair groove RH may overlap the repair area 11r. The repair groove RH may be formed in the buffer layer 20 and the passivation layer 30. The light-shielding pattern 11 and the repair pattern 142 provided in the repair area 11r may be brought into contact with the repair groove RH through a laser process.

The hole OH may overlap the repair area 11r and may overlap the repair groove RH internally. The hole OH may be formed in the overcoat layer 40. The hole OH of the overcoat layer 40 may be made of an area greater than the repair groove RH and may expose the repair groove RH during a process.

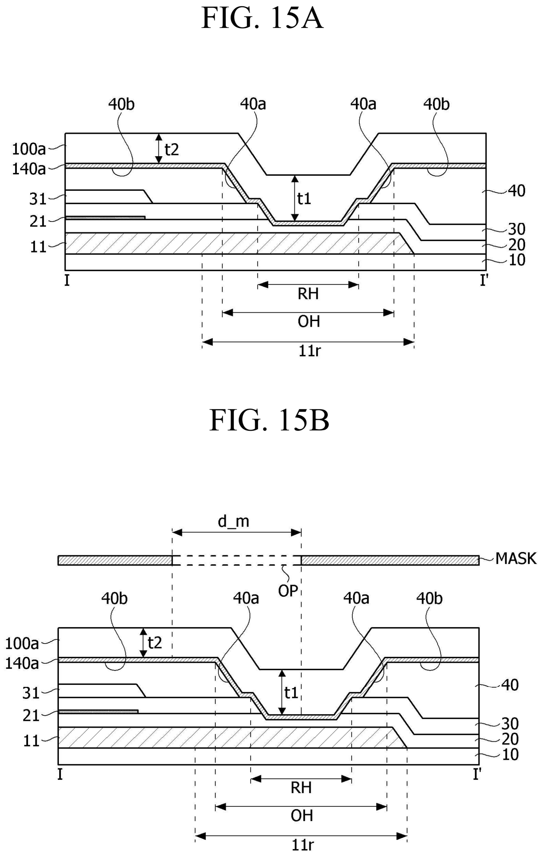

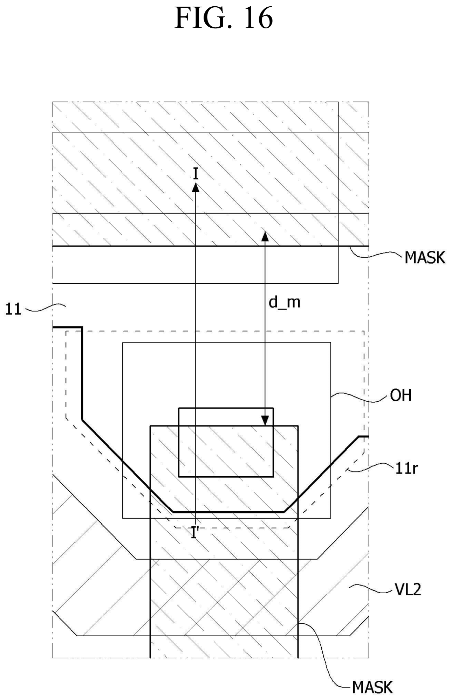

FIGS. 15A to 15G are process views with respect to a cross-sectional view of FIG. 14 taken along line I-I'. FIG. 16 is a plan view of a mask illustrated in FIG. 15B.

Referring to FIG. 15A, the display panel according to an example of the present disclosure may include the substrate 10, the light-shielding pattern 11 provided on the substrate 10, the buffer layer 20 provided on the light-shielding pattern 11, the passivation layer 30 provided on the buffer layer 20, a semiconductor layer 21 provided between the buffer layer 20 and the passivation layer 30, the overcoat layer 40 provided on the passivation layer 30, a color filter layer 31 provided between the passivation layer 30 and the overcoat layer 40, an anode electrode material layer 140a provided on the overcoat layer 40, and a primary photosensitive pattern 100a provided on the anode electrode material layer 140.

Here, the buffer layer 20 and the passivation layer 30 may include the repair groove RH. The repair groove RH may have a shape in which an entire thickness of the passivation layer 30 is removed and a partial thickness of the buffer layer 20 is removed. It should be noted that the thickness of the repair groove RH according to the example is not limited thereto. For example, the repair groove RH may have a shape in which only the passivation layer 30 is removed.

The overcoat layer 40 may include an upper surface 40b opposite to a surface in contact with the passivation layer 30, and an inner side surface 40a that extends from the upper surface to form the hole OH. The thickness of the overcoat layer 40 may be greater than a total thickness of at least the buffer layer 20 and the passivation layer 30.

The hole OH of the overcoat layer 40 may have a shape in which the entire thickness of the overcoat layer 40 is removed and the hole passes through the overcoat layer 40. The hole OH of the overcoat layer 40 may have an area greater than the repair groove RH, and the repair groove RH may overlap on the inside thereof. The repair groove RH may be exposed from the hole OH of the overcoat layer 40.

The anode electrode material layer 140a may be formed over the display area of the substrate 10. The anode electrode material layer 140a may be formed over the upper surface 40b and the inner side surface 40a of the overcoat layer 40 and the repair groove RH.

The primary photosensitive pattern 100a may entirely cover the anode electrode material layer 140a. The primary photosensitive pattern 100a may have a maximum of a first thickness t1 in the hole OH of the overcoat layer 40 and the repair groove RH and have a second thickness t2 on the upper surface 40b of the overcoat layer 40. Here, the first and second thicknesses t1 and t2 are a vertical distance from a lower surface of the primary photosensitive pattern 100a in contact with the anode electrode material layer 140a to a front surface of the primary photosensitive pattern 100a.

The primary photosensitive pattern 100a may have at least the first thickness t1 greater than the second thickness t2. The first thickness t1 of the primary photosensitive pattern 100a may be equal to or greater than the thickness of at least the overcoat layer 40.

Referring to FIGS. 15B and 16, a mask MASK that faces the substrate 10 may be provided and an exposure process may be performed. The mask MASK may include an opening OP.

The opening OP may have a second distance d_m in an opening area. The opening OP may overlap a part of the upper surface 40b of the overcoat layer 40, a part of the hole OH of the overcoat layer 40, and a part of the repair groove RH. In this case, the opening OP may overlap an entire area in which the first and second different thicknesses t1 and t2 of at least the primary photosensitive pattern 100a are formed.

Since an area of the primary photosensitive pattern 100a having the second thickness t2 has a thickness relatively thicker than the first thickness t1, light (for example, ultraviolet ray) may not penetrate to a deep place. Accordingly, during the exposure process, the exposure process may be performed to such an extent as to remove the primary photosensitive pattern 100a of the first thickness t1.

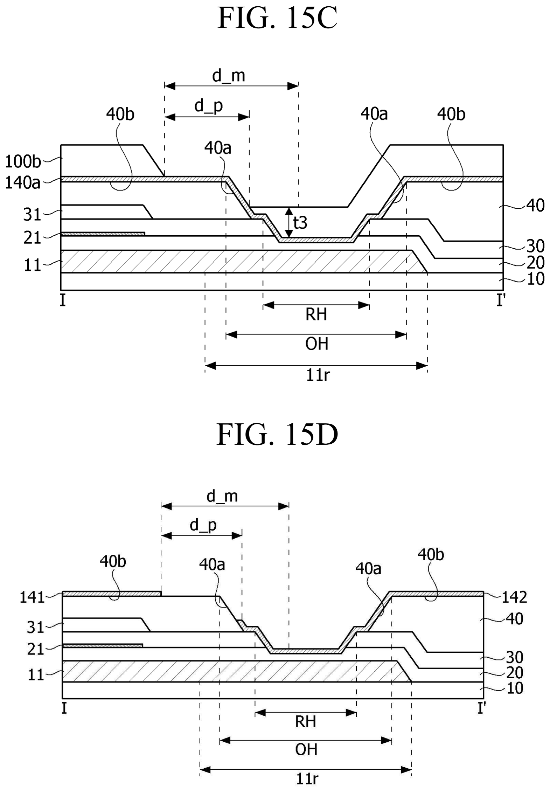

Referring to FIG. 15C, the mask MASK may be removed, and a development process may be performed. In the development process, an area of the primary photosensitive pattern 100a having the first thickness t1 may be entirely removed, and the area of the primary photosensitive pattern 100a having the second thickness t2 may be partially removed. Accordingly, a secondary photosensitive pattern 100b may expose the anode electrode material layer 140a that overlaps the upper surface 40b and the inner side surface 40a of the overcoat layer 40.

In this case, a first distance d_p of an opened area of the secondary photosensitive pattern 100b actually developed may be narrower than the second distance d_m of the opening OP of the mask MASK. Here, the first distance d_p may be a horizontal distance of the opened area of the secondary photosensitive pattern 100b.

Referring to FIG. 15D, the anode electrode material layer 140a may be etched, and the first portion 141 and the repair pattern 142 of the anode electrode may be formed.

A horizontal distance between the first portion 141 and the repair pattern 142 of the anode electrode may be made as the first distance d_p. Here, the first distance d_p may be a minimum distance capable of preventing short-circuiting between anode electrodes.

The repair pattern 142 may expose at least a part of the inner side surface 40a of the overcoat layer 40. That is, the repair pattern 142 may be stably formed in the repair groove RH, but may not be entirely formed in the hole OH of the overcoat layer 40.

Accordingly, with the display panel according to the example of the present disclosure, it is possible to improve an opening area that defines a light-emitting part of a sub-pixel, by an area of the inner side surface 40a of the overcoat layer 40 where the repair pattern 142 is not formed.

Further, since the first portion 141 and the repair pattern 142 are spaced in the horizontal direction with the inner side surface 40a of the overcoat layer 40 interposed therebetween, it is possible to minimize the occurrence of short-circuiting. That is, with the display panel according to the example of the present disclosure, it is possible to improve an opening area that defines a light-emitting part of a sub-pixel, by the upper surface 40b of the overcoat layer 40 exposed from the first portion 141 of the anode electrode.

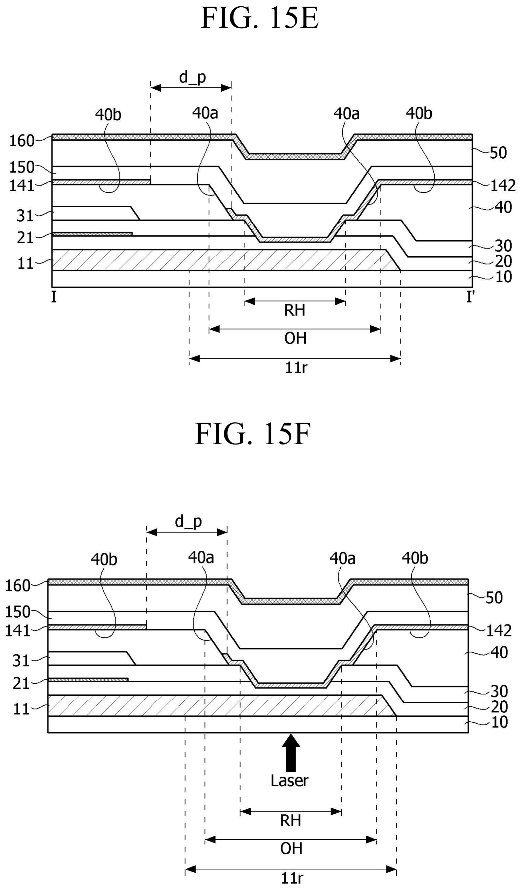

Referring to FIG. 15E, an intermediate layer 150 including a light-emitting layer, a bank 50, and a cathode electrode 160 may be sequentially formed on the anode electrode including the first portion 141 and the repair pattern 142.

Referring to FIG. 15F, when a certain sub-pixel operates abnormally, a laser process may be performed. The laser process may be performed by laser irradiation toward the repair groove RH from below the substrate 10. The light-shielding pattern 11 may be welded by the laser process.

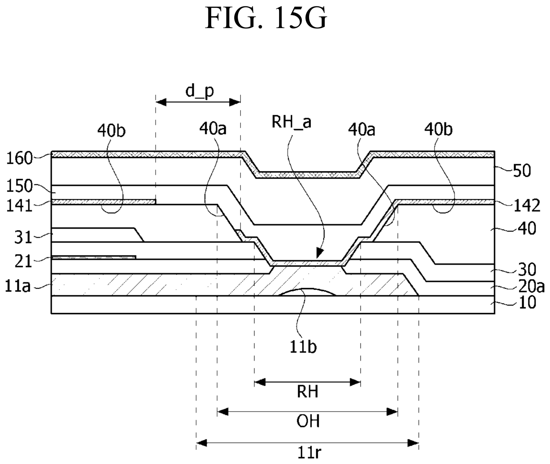

Referring to FIG. 15G, the light-shielding pattern 11 may be welded and a repair light-shielding pattern 11a may be formed. In the repair groove RH, a repair hole RH_a may be formed.

The repair light-shielding pattern 11a may be in contact with the repair pattern 142 of the anode electrode in an area of the repair hole RH_a. Then, a void 11b may be formed between the repair light-shielding pattern 11a and the substrate 10.

The repair hole RH_a may include a hole of a buffer layer (20 in FIG. 15F) formed by the repair light-shielding pattern 11a. The repair hole RH_a may include a hole of a repair buffer layer 20a, and may also include a hole of the passivation layer 30.

According to the processes of FIGS. 15F and 15G, it is possible to drive a certain sub-pixel that operates abnormally.

Accordingly, the above-described examples should be understood as exemplary in all aspects and not restrictive.

The scope of the present disclosure should be interpreted by the claims, and it should be interpreted that all technical ideas within the equivalent range are included in the scope of the present disclosure.

The various examples described above can be combined to provide further examples. These and other changes can be made to the examples in light of the above-detailed description. In general, in the following claims, the terms used should not be construed to limit the claims to the specific examples disclosed in the disclosure and the claims, but should be construed to include all possible examples along with the full scope of equivalents to which such claims are entitled. Accordingly, the claims are not limited by the disclosure.

Described herein are also the following clauses:
1. A display panel comprising: a plurality of sub-pixels; a first data line including a first multiple-wire part and a first single-wire part provided alternately in a first direction; and a second data line including a second multiple-wire part and a second single-wire part provided alternately in the first direction, wherein the first multiple-wire part and the second single-wire part are provided between the plurality of sub-pixels in a second direction intersecting the first direction, and the first single-wire part and the second multiple-wire part are provided between the plurality of sub-pixels in the second direction.
2. The display panel according to clause 1, wherein the first multiple-wire part and the second single-wire part are provided in parallel in the second direction, and the first single-wire part and the second multiple-wire part are provided in parallel in the second direction.
3. The display panel according to clause 1, wherein the first multiple-wire part includes: a first data wire part provided in the first direction; and a first overlap pattern that partially overlaps the first data wire part along the first data wire part, wherein the second multiple-wire part includes: a second data wire part provided in the first direction; and a second overlap pattern that partially overlaps the second data wire part along the second data wire part, and wherein the first overlap pattern and the second overlap pattern do not overlap each other in the second direction.
4. The display panel according to clause 3, wherein: the first and second data wire parts are provided in the same layer, and the first and second overlap patterns are provided in the same layer.
5. The display panel according to clause 3, wherein: the plurality of sub-pixels include a plurality of first sub-pixels and a plurality of second sub-pixels provided alternately in the first direction, the first multiple-wire part and the second single-wire part are provided on one side in the second direction for each of the plurality of first sub-pixels, and the first single-wire part and the second multiple-wire part are provided on one side in the second direction for each of the plurality of second sub-pixels.
6. The display panel according to clause 5, wherein: the display panel has a plane having the first direction and the second direction, each of the first and second overlap patterns includes first contacts that are in contact with each of the first and second data wire parts, each of the first and second single-wire parts includes mask patterns having the same area as the first contacts.
7. The display panel according to clause 6, wherein the number of first contacts provided in each of the first and second overlap patterns is equal to the number of mask patterns provided in each of the first and second single-wire parts.
8. The display panel according to clause 1, wherein: the plurality of sub-pixels are provided in the first direction, and the first multiple-wire part, the second single-wire part, the first single-wire part, and the second multiple-wire part are provided on one side in a second direction intersecting the first direction for each of the plurality of sub-pixels.
9. The display panel according to clause 1, wherein the first and second data lines supply a data voltage to the plurality of sub-pixels.
10. The display panel according to clause 1, further comprising: a first gate line and a second gate line provided in a second direction intersecting the first direction, wherein the first and second data lines supply the same data voltage to the sub-pixels, one of the plurality of sub-pixels is driven by the first data line and the first gate line, and another one of the plurality of sub-pixels is driven by the second data line and the second gate line.
11. The display panel according to clause 1, further comprising: a plurality of driving voltage lines provided in the first direction; a plurality of driving voltage connection patterns that connect the plurality of driving voltage lines; a plurality of reference voltage lines provided between the plurality of driving voltage lines in the first direction; and a semiconductor pattern, wherein each of the driving voltage connection patterns includes at least one first section provided between the plurality of driving voltage lines in the first direction, the first section of each of the driving voltage connection patterns overlaps the reference voltage line and the semiconductor pattern is provided between the first section of each of the driving voltage connection patterns and the reference voltage line that overlap each other.
12. The display panel according to clause 6, wherein the first contacts are provided on both sides of each of the first overlap pattern and the second overlap pattern with respect to the first direction.
13. The display panel according to clause 1, wherein each of the first multiple-wire part and the second multiple-wire part is made in a shape in which two patterns overlap in a direction intersect with the fist direction and the second direction.
14. The display panel according to clause 3, wherein the first overlap pattern is on the first data wire part, and the second overlap pattern is on the second data wire part.
15. A display panel comprising: a substrate including a plurality of first sub-pixels and a plurality of second sub-pixels spaced apart from the plurality of first sub-pixels in a first direction; a first data wire part and a second data wire part that are provided between the plurality of first and second sub-pixels on the substrate and are spaced apart from each other in the first direction; a first overlap pattern that is provided on the first data wire part and overlaps a part of the first data wire part; and a second overlap pattern that is provided on the second data wire part and overlaps a part of the second data wire part, wherein the first overlap pattern and the second overlap pattern are provided in the same layer and do not overlap each other in a second direction intersecting the first direction.
16. The display panel according to clause 15, wherein: the first overlap pattern is positioned between any first and second sub-pixels provided adjacent to each other in the first direction, and the second overlap pattern is positioned between another first and second sub-pixels provided adjacent to each other in the first direction.
17. The display panel according to clause 15, wherein the first and second overlap patterns are positioned between any first and second sub-pixels provided adjacent to each other in the first direction.
18. The display panel according to clause 15, wherein the first and second data wire parts supply a data voltage to the plurality of first and second sub-pixels.
19. The display panel according to clause 15, further comprising: a first gate line and a second gate line, wherein the first and second data wire parts supply the same data voltage to the plurality of first and second sub-pixels, the plurality of first sub-pixels are driven by the first data wire part and the first gate line, and the plurality of second sub-pixels are driven by the second data wire part and the second gate line.
20. A display panel comprising: a light-shielding pattern that is provided in each of a plurality of pixels and includes a repair area; an insulating layer that is provided on the light-shielding pattern and includes a repair groove positioned in the repair area; an overcoat layer that is provided on the insulating layer and includes a hole in which the repair groove is provided; and an anode electrode that is provided on the overcoat layer and is provided in each of the plurality of pixels, wherein the anode electrode includes a repair pattern that extends from one pixel to another neighboring pixel and overlaps the repair groove, the hole of the overcoat layer is formed by an inner side surface bent from an upper surface of the overcoat layer, and the repair pattern exposes at least a part of the inner side surface of the hole and is provided in the repair groove.
Described herein are also the following items:
1. A display panel comprising: a plurality of sub-pixels; a first data line including a first multiple-wire part and a first single-wire part provided alternately in a first direction; and a second data line including a second multiple-wire part and a second single-wire part provided alternately in the first direction, wherein the first multiple-wire part and the second single-wire part are provided between the plurality of sub-pixels in a second direction intersecting the first direction, and the first single-wire part and the second multiple-wire part are provided between the plurality of sub-pixels in the second direction.
2. The display panel according to item 1, wherein the first multiple-wire part and the second single-wire part are provided in parallel in the second direction, and the first single-wire part and the second multiple-wire part are provided in parallel in the second direction.
3. The display panel according to any preceding item, wherein the first multiple-wire part includes: a first data wire part provided in the first direction; and a first overlap pattern that partially overlaps the first data wire part along the first data wire part, wherein the second multiple-wire part includes: a second data wire part provided in the first direction; and a second overlap pattern that partially overlaps the second data wire part along the second data wire part, and wherein the first overlap pattern and the second overlap pattern do not overlap each other in the second direction.
4. The display panel according to item 3, wherein: the first and second data wire parts are provided in the same layer, and the first and second overlap patterns are provided in the same layer; and optionally wherein the first overlap pattern is on the first data wire part, and the second overlap pattern is on the second data wire part.
5. The display panel according to any one of the items 3 to 4, wherein: the plurality of sub-pixels include a plurality of first sub-pixels and a plurality of second sub-pixels provided alternately in the first direction, the first multiple-wire part and the second single-wire part are provided on one side in the second direction for each of the plurality of first sub-pixels, and the first single-wire part and the second multiple-wire part are provided on one side in the second direction for each of the plurality of second sub-pixels.
6. The display panel according to item 5, wherein: the display panel has a plane having the first direction and the second direction, each of the first and second overlap patterns includes first contacts that are in contact with each of the first and second data wire parts, each of the first and second single-wire parts includes mask patterns having the same area as the first contacts; and optionally, wherein the first contacts are provided on both sides of each of the first overlap pattern and the second overlap pattern with respect to the first direction.
7. The display panel according to item 6, wherein the number of first contacts provided in each of the first and second overlap patterns is equal to the number of mask patterns provided in each of the first and second single-wire parts.
8. The display panel according to item 1, wherein: the plurality of sub-pixels are provided in the first direction, and the first multiple-wire part, the second single-wire part, the first single-wire part, and the second multiple-wire part are provided on one side in a second direction intersecting the first direction for each of the plurality of sub-pixels.
9. The display panel according to any preceding item, wherein the first and second data lines supply a data voltage to the plurality of sub-pixels.
10. The display panel according to any preceding item, further comprising: a first gate line and a second gate line provided in a second direction intersecting the first direction, wherein the first and second data lines supply the same data voltage to the sub-pixels, one of the plurality of sub-pixels is driven by the first data line and the first gate line, and another one of the plurality of sub-pixels is driven by the second data line and the second gate line.
11. The display panel according to any preceding item, further comprising: a plurality of driving voltage lines provided in the first direction; a plurality of driving voltage connection patterns that connect the plurality of driving voltage lines; a plurality of reference voltage lines provided between the plurality of driving voltage lines in the first direction; and a semiconductor pattern, wherein each of the driving voltage connection patterns includes at least one first section provided between the plurality of driving voltage lines in the first direction, the first section of each of the driving voltage connection patterns overlaps the reference voltage line and the semiconductor pattern is provided between the first section of each of the driving voltage connection patterns and the reference voltage line that overlap each other.
12. The display panel according to any preceding item, wherein each of the first multiple-wire part and the second multiple-wire part is made in a shape in which two patterns overlap in a direction intersect with the fist direction and the second direction.
13. The display panel according to item 1, further comprising: a substrate including a plurality of first sub-pixels and a plurality of second sub-pixels spaced apart from the plurality of first sub-pixels in a first direction; a first data wire part and a second data wire part that are provided between the plurality of first and second sub-pixels on the substrate and are spaced apart from each other in the first direction; a first overlap pattern that is provided on the first data wire part and overlaps a part of the first data wire part; and a second overlap pattern that is provided on the second data wire part and overlaps a part of the second data wire part, wherein the first overlap pattern and the second overlap pattern are provided in the same layer and do not overlap each other in a second direction intersecting the first direction.
14. The display panel according to item 13, wherein: the first overlap pattern is positioned between any first and second sub-pixels provided adjacent to each other in the first direction, and the second overlap pattern is positioned between another first and second sub-pixels provided adjacent to each other in the first direction; and optionally wherein the first and second overlap patterns are positioned between any first and second sub-pixels provided adjacent to each other in the first direction; and optionally wherein the first and second data wire parts supply a data voltage to the plurality of first and second sub-pixels; and optionally wherein the display apparatus further comprising: a first gate line and a second gate line, wherein the first and second data wire parts supply the same data voltage to the plurality of first and second sub-pixels, the plurality of first sub-pixels are driven by the first data wire part and the first gate line, and the plurality of second sub-pixels are driven by the second data wire part and the second gate line.
15. The display panel according to any preceding item, further comprising: a light-shielding pattern that is provided in each of a plurality of pixels and includes a repair area; an insulating layer that is provided on the light-shielding pattern and includes a repair groove positioned in the repair area; an overcoat layer that is provided on the insulating layer and includes a hole in which the repair groove is provided; and an anode electrode that is provided on the overcoat layer and is provided in each of the plurality of pixels, wherein the anode electrode includes a repair pattern that extends from one pixel to another neighboring pixel and overlaps the repair groove, the hole of the overcoat layer is formed by an inner side surface bent from an upper surface of the overcoat layer, and the repair pattern exposes at least a part of the inner side surface of the hole and is provided in the repair groove.

## Claims

1. A display panel comprising:
a plurality of sub-pixels;
a first data line including a first multiple-wire part and a first single-wire part provided alternately in a first direction; and
a second data line including a second multiple-wire part and a second single-wire part provided alternately in the first direction,
wherein the first multiple-wire part and the second single-wire part are provided between the plurality of sub-pixels in a second direction intersecting the first direction, and
the first single-wire part and the second multiple-wire part are provided between the plurality of sub-pixels in the second direction.

2. The display panel according to claim 1, wherein the first multiple-wire part and the second single-wire part are provided in parallel in the second direction, and the first single-wire part and the second multiple-wire part are provided in parallel in the second direction.

3. The display panel according to any preceding claim, wherein the first multiple-wire part includes:
a first data wire part provided in the first direction; and
a first overlap pattern that partially overlaps the first data wire part along the first data wire part,
wherein the second multiple-wire part includes:
a second data wire part provided in the first direction; and
a second overlap pattern that partially overlaps the second data wire part along the second data wire part, and
wherein the first overlap pattern and the second overlap pattern do not overlap each other in the second direction.

4. The display panel according to claim 3, wherein:
the first and second data wire parts are provided in the same layer, and
the first and second overlap patterns are provided in the same layer,
and optionally wherein the first overlap pattern is on the first data wire part, and the second overlap pattern is on the second data wire part.

5. The display panel according to any one of the claims 3 to 4, wherein:
the plurality of sub-pixels include a plurality of first sub-pixels and a plurality of second sub-pixels provided alternately in the first direction,
the first multiple-wire part and the second single-wire part are provided on one side in the second direction for each of the plurality of first sub-pixels, and
the first single-wire part and the second multiple-wire part are provided on one side in the second direction for each of the plurality of second sub-pixels.

6. The display panel according to claim 5, wherein:
the display panel has a plane having the first direction and the second direction,
each of the first and second overlap patterns includes first contacts that are in contact with each of the first and second data wire parts,
each of the first and second single-wire parts includes mask patterns having the same area as the first contacts,
and optionally, wherein the first contacts are provided on both sides of each of the first overlap pattern and the second overlap pattern with respect to the first direction.

7. The display panel according to claim 6, wherein the number of first contacts provided in each of the first and second overlap patterns is equal to the number of mask patterns provided in each of the first and second single-wire parts.

8. The display panel according to claim 1, wherein:
the plurality of sub-pixels are provided in the first direction, and
the first multiple-wire part, the second single-wire part, the first single-wire part, and the second multiple-wire part are provided on one side in a second direction intersecting the first direction for each of the plurality of sub-pixels.

9. The display panel according to any preceding claim, wherein the first and second data lines supply a data voltage to the plurality of sub-pixels.

10. The display panel according to claim 1, further comprising:
a first gate line and a second gate line provided in a second direction transverse to the first direction,
wherein the first and second data lines supply the same data voltage to the sub-pixels,
wherein one of the plurality of sub-pixels is driven by the first data line and the first gate line, and
wherein another one of the plurality of sub-pixels is driven by the second data line and the second gate line.

11. The display panel according to any preceding claim, further comprising:
a plurality of driving voltage lines provided in the first direction;
a plurality of driving voltage connection patterns that connect the plurality of driving voltage lines;
a plurality of reference voltage lines provided between the plurality of driving voltage lines in the first direction; and
a semiconductor pattern,
wherein each of the driving voltage connection patterns includes at least one first section provided between the plurality of driving voltage lines in the first direction, and
wherein the first section of each of the driving voltage connection patterns overlaps the reference voltage line and the semiconductor pattern is provided between the first section of each of the driving voltage connection patterns and the reference voltage line that overlap each other.

12. The display panel according to any preceding claim, wherein each of the first multiple-wire part and the second multiple-wire part is made in a shape in which two patterns overlap in a direction intersect with the fist direction and the second direction.

13. The display panel according to claim 1, further comprising:
a substrate including a plurality of first sub-pixels and a plurality of second sub-pixels spaced apart from the plurality of first sub-pixels in a first direction;
a first data wire part and a second data wire part that are provided between the plurality of first and second sub-pixels on the substrate and are spaced apart from each other in the first direction;
a first overlap pattern that is provided on the first data wire part and overlaps a part of the first data wire part; and
a second overlap pattern that is provided on the second data wire part and overlaps a part of the second data wire part,
wherein the first overlap pattern and the second overlap pattern are provided in the same layer and do not overlap each other in a second direction intersecting the first direction.

14. The display panel according to claim 13, wherein:
the first overlap pattern is positioned between any first and second sub-pixels provided adjacent to each other in the first direction, and
the second overlap pattern is positioned between another first and second sub-pixels provided adjacent to each other in the first direction,
and optionally wherein the first and second overlap patterns are positioned between any first and second sub-pixels provided adjacent to each other in the first direction;
and optionally wherein the first and second data wire parts supply a data voltage to the plurality of first and second sub-pixels;
and optionally wherein the display apparatus further comprising:
a first gate line and a second gate line,
wherein the first and second data wire parts supply the same data voltage to the plurality of first and second sub-pixels,
the plurality of first sub-pixels are driven by the first data wire part and the first gate line, and
the plurality of second sub-pixels are driven by the second data wire part and the second gate line.

15. The display panel according to any preceding claim, further comprising:
a light-shielding pattern that is provided in each of a plurality of pixels and includes a repair area;
an insulating layer that is provided on the light-shielding pattern and includes a repair groove positioned in the repair area;
an overcoat layer that is provided on the insulating layer and includes a hole in which the repair groove is provided; and
an anode electrode that is provided on the overcoat layer and is provided in each of the plurality of pixels,
wherein the anode electrode includes a repair pattern that extends from one pixel to another neighboring pixel and overlaps the repair groove,
wherein the hole of the overcoat layer is formed by an inner side surface bent from an upper surface of the overcoat layer, and
wherein the repair pattern exposes at least a part of the inner side surface of the hole and is provided in the repair groove.
